# EUROPEAN PATENT APPLICATION

(11) **EP 2 897 381 A1**
(43) Date of publication of application: **22.07.2015**
(21) Application number: 15153584.6
(22) Date of filing: 05.12.2011
(51) Int. Cl.: H04R 17/10, H04R 3/00, H04R 17/00, B06B 1/06, G10K 9/122, H01L 41/053, H01L 41/193

(54) **Oscillator and electronic device**

(30) Priority: 31.03.2011 JP 2011079027
(62) Divisional of application: 11862661.3
(71) Applicant: NEC CASIO Mobile Communications, Ltd., Kawasaki-shi Kanagawa 211-8666 (JP)
(72) Inventor: Onishi, Yasuharu, Kawasaki-shi, Kanagawa 211-8666 (JP); Kuroda, Jun, Kawasaki-shi, Kanagawa 211-8666 (JP); Kishinami, Yuichiro, Kawasaki-shi, Kanagawa 211-8666 (JP); Murata, Yukio, Kawasaki-shi, Kanagawa 211-8666 (JP); Satou, Shigeo, Kawasaki-shi, Kanagawa 211-8666 (JP); Kawashima, Nobuhiro, Kawasaki-shi, Kanagawa 211-8666 (JP); Komoda, Motoyoshi, Kawasaki-shi, Kanagawa 211-8666 (JP); Uchikawa, Tatsuya, Kawasaki-shi, Kanagawa 211-8666 (JP)
(74) Representative: Vossius & Partner Patentanwälte Rechtsanwälte mbB

(57) **Abstract**

A piezoelectric element (20) is attached to a vibration member (10). A plurality of electrodes (22) are two-dimensionally arranged on one surface of the piezoelectric element (20) so as to be spaced apart from each other. A supporting frame (40) supports an edge of the vibration member (10). A control unit (50) inputs an independent driving signal to each of the plurality of electrodes (22). Thus, a large output can be obtained with a resonance frequency depending on what signal is input to which electrode (22). For example, the piezoelectric element (20) is a resin film that is formed of a high molecular material indicating a piezoelectric property.

## Description

### TECHNICAL FIELD

The present invention relates to an oscillator and an electronic device.

### BACKGROUND ART

Oscillators using a piezoelectric material are used as, for example, a parametric speaker, or an oscillation source of an ultrasonic wave sensor.

Patent Document 1 discloses that a circular piezoelectric element is divided into a plurality of regions in a radial direction, and a signal is directly input to each of the divided regions. Patent Document 2 discloses that an electrode formed on a piezoelectric film is one-dimensionally divided into a plurality of parts.

In addition, Patent Document 3 discloses that four corners of a rectangular piezoelectric plate formed of lithium niobate are supported by a metal supporting plate that protrudes from an internal wall of a supporting frame. Patent Document 4 discloses that a metal vibrating plate and a piezoelectric ceramic plate are fixed to a center portion of a foamed resin sheet, and a rigid frame is fixed to an edge of the foamed resin sheet.

### RELATED DOCUMENT

### PATENT DOCUMENT

[Patent Document 1] Japanese Unexamined Utility Model Registration Publication No. 62-10594
[Patent Document 2] Japanese Unexamined Patent Publication No. 2003-143694
[Patent Document 3] Japanese Unexamined Patent Publication No. 7-106660
[Patent Document 4] Japanese Unexamined Patent Publication No. 3-201800

### DISCLOSURE OF THE INVENTION

When the oscillator is used as a parametric speaker or an oscillation source of an ultrasonic wave sensor, the oscillator is required to obtain a large output with a resonance frequency.

An object of the invention is to provide an oscillator and an electronic device that can obtain a large output with a resonance frequency.

According to the invention, there is provided an oscillator including a vibration member; a piezoelectric element that is attached to the vibration member; a plurality of electrodes that are provided on one surface of the piezoelectric element and are two-dimensionally arranged so as to be spaced apart from each other; a supporting member that supports an edge of the vibration member; and a control unit that inputs an independent driving signal to each of the plurality of electrodes.

According to the invention, there is provided an oscillator including a vibration member; a piezoelectric element that is attached to the vibration member; a plurality of electrodes that are provided on one surface of the piezoelectric element and are two-dimensionally arranged so as to be spaced apart from each other; and a frame to which the vibration member is fixed. A plane of an inner circumference of the frame has a polygonal shape of which all corners have an angle that is equal to or less than 180 degrees when seen in a plan view. At least one of corners of the frame has a reinforcing member that is fixed to the frame and the vibration member.

According to the invention, it is possible to obtain a large output with a resonance frequency.

### BRIEF DESCRIPTION OF THE DRAWINGS

The above-described objects, other objects, features and advantages will be further apparent from the preferred embodiments described below, and the accompanying drawings as follows.
FIG. 1 is a diagram illustrating a configuration of an oscillator according to a first embodiment.
FIG. 2 is a plan view of the oscillator illustrated in FIG. 1.
FIG. 3 is a diagram illustrating a state where the oscillator illustrated in FIG. 2 is attached to an electronic device.
FIG. 4 is a plan view illustrating a configuration of an oscillator according to a second embodiment.
FIG. 5 is a plan view illustrating a configuration of an oscillator according to a third embodiment.
FIG. 6 is a cross-sectional view taken along line A-A' of FIG. 5.
FIG. 7 is a cross-sectional view taken along line B-B' of FIG. 5.
FIG. 8 is a cross-sectional view illustrating a modified example of FIG. 7.
FIG. 9 is a cross-sectional view illustrating a modified example of FIG. 7.
FIG. 10 is a cross-sectional view illustrating a modified example of FIG. 7.

### DESCRIPTION OF EMBODIMENTS

Hereinafter, embodiments of the invention will be described with reference to the accompanying drawings. In addition, in all the drawings, the same component is denoted by the same reference numeral and description will not be repeated.

### (First Embodiment)

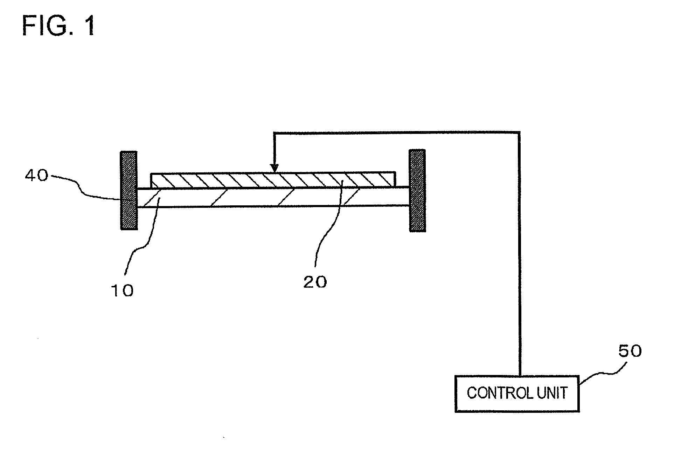

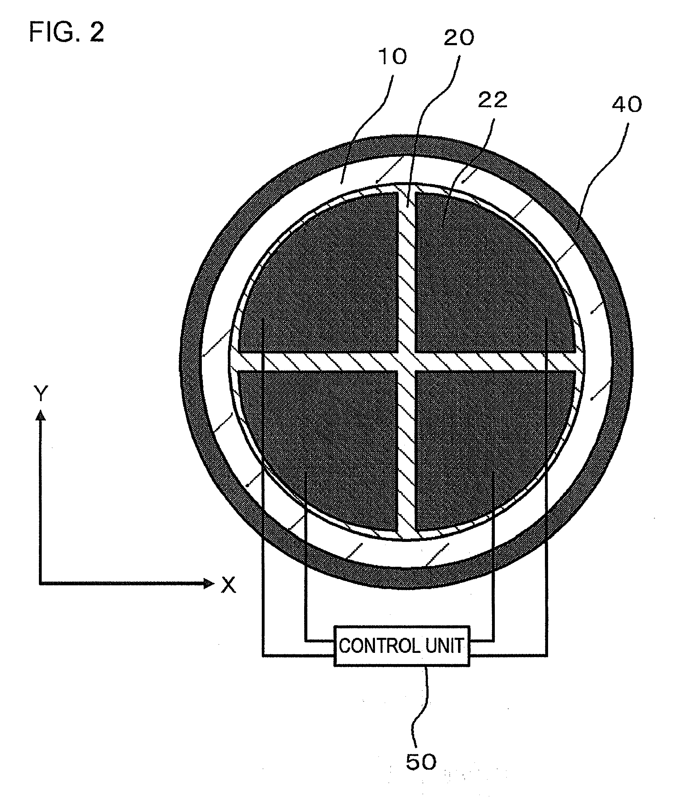

FIG. 1 is a diagram illustrating a configuration of an oscillator according to a first embodiment. FIG. 2 is a plan view of the oscillator illustrated in FIG. 1. The oscillator has a vibration member 10, a piezoelectric element 20, a supporting member (a supporting frame) 40, and a control unit 50. The piezoelectric element 20 is attached to the vibration member 10. A plurality of electrodes 22 are two-dimensionally arranged on one surface of the piezoelectric element 20 so as to be spaced apart from each other. The supporting frame 40 supports an edge of the vibration member 10. The control unit 50 inputs an independent driving signal to each of the plurality of electrodes 22. For this reason, it is possible to obtain a large output with a resonance frequency depending on what signal is input to which electrode 22. Hereinafter, it will be described in detail.

The vibration member 10 has a sheet shape, and vibrates through the vibration generated from the piezoelectric element 20. In addition, the vibration member 10 adjusts a fundamental resonance frequency of the piezoelectric element 20. A fundamental resonance frequency of a mechanical vibrator depends on load weight and compliance. Since the compliance is a mechanical rigidity of a vibrator, the fundamental resonance frequency of the piezoelectric element 20 can be controlled by controlling the rigidity of the vibration member 10. Meanwhile, the thickness of the vibration member 10 is preferably equal to or more than 5 µm and equal to or less than 500 µm. In addition, it is preferable that the vibration member 10 has a longitudinal elastic modulus, which is an index indicating rigidity, of equal to or more than 1 Gpa and equal to or less than 500 GPa. When the rigidity of the vibration member 10 is excessively low or excessively high, there is a possibility of the characteristics and reliability of a mechanical vibrator being damaged. Meanwhile, the material constituting the vibration member 10 is not particularly limited as long as it is a material, such as a metal or a resin, having a high elastic modulus with respect to the piezoelectric element 20 which is formed of a brittle material, but is preferably phosphor bronze, stainless steel or the like from the viewpoint of workability or costs.

The piezoelectric element 20 is, for example, a resin film that is formed of a high molecular material indicating a piezoelectric property. The piezoelectric element 20 is formed of, for example, polyvinylidene fluoride, but the invention is not limited thereto. In addition, the piezoelectric element 20 may be formed of piezoelectric ceramics such as PZT. In any of the above cases, the planar shape of the piezoelectric element 20 is smaller than that of the vibration member 10.

As illustrated in FIG. 2, the plurality of electrodes 22 are two-dimensionally arranged on one surface of the piezoelectric element 20 so as to be spaced apart from each other. In detail, the piezoelectric element 20 is virtually divided into a plurality of regions in an X direction and a Y direction. The electrode 22 is formed in each of the divided regions. It is preferable that the regions have the same planar shape. In this case, it is preferable that the electrodes 22 have the same planar shape and that the electrodes 22 be arranged at equal intervals. In addition, it is preferable that at least some of the electrodes 22 be arranged so as to be point-symmetrical to each other based on the center of the piezoelectric element 20.

In the example shown in the drawing, the planar shape of the piezoelectric element 20 is circular. Thus, the vibration member 10 also has a circular shape, and the supporting frame 40 also has a shape along the circumference of the vibration member. The vibration member 10, the piezoelectric element 20, and the supporting frame 40 are disposed so as to be concentric with each other. The piezoelectric element 20 is virtually divided at equal angles (for example, 90 degrees) in a circumferential direction based on the center of the piezoelectric element 20. The fan-like electrode 22 is provided in each of the divided regions. In other words, the piezoelectric element 20 is virtually divided into two equal parts when seen in a cross-section passing through the center of the piezoelectric element 20, and the electrode 22 is provided in each of the regions.

Meanwhile, a ground electrode may be provided on the entirety of the other surface of the piezoelectric element 20, and the ground electrode may be provided in the form of an island only in a portion overlapping the electrode 22 when seen in a plan view.

The control unit 50 inputs an independent driving signal to each of the plurality of electrodes 22. For example, when the oscillator is used as a parametric speaker, the control unit 50 modulates sound data that is input from the outside to generate the modulated data for the parametric speaker, generates an oscillation signal based on the modulated data, and inputs the oscillation signal to the piezoelectric element 20.

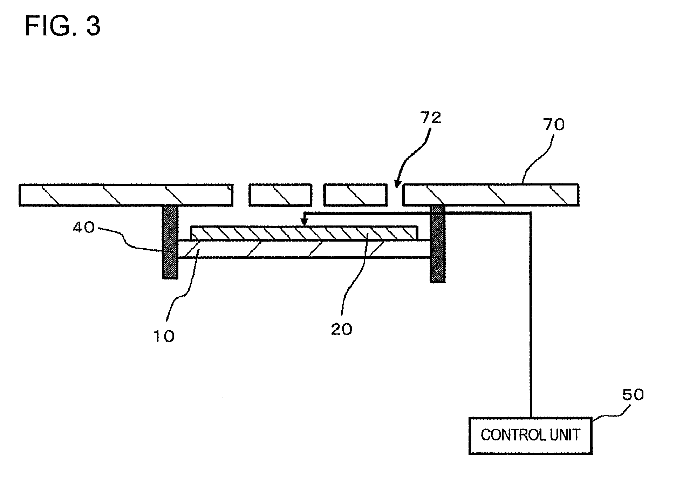

FIG. 3 is a diagram illustrating a state where the oscillator illustrated in FIG. 2 is attached to an electronic device. In the example shown in FIG. 3, the oscillator is attached to an internal wall of a housing 70 of the electronic device. In detail, a top surface of the supporting frame 40 is attached to the internal wall of the housing 70. The housing 70 is provided with sound holes 72. The supporting frame 40 includes the sound holes 72 on the inside thereof when seen in a plan view. For this reason, the sound holes 72 face the vibration member 10 and the piezoelectric element 20, and a sound wave oscillated from the vibration member 10 and the piezoelectric element 20 is radiated to the outside of the housing 70 through the sound holes 72.

Next, operations and effects of the embodiment will be described. When a sound wave having a fundamental resonance frequency of the vibration member 10 and the piezoelectric element 20 is output from the oscillator, the control unit 50 inputs a driving signal having a fundamental resonance frequency to all the electrodes 22 in the same phase. Then, the vibration member 10 and the piezoelectric element 20 vibrate with the fundamental resonance frequency.

In addition, when a sound wave having a second-order resonance frequency of the vibration member 10 and the piezoelectric element 20 is output from the oscillator, the control unit 50 outputs a driving signal having the second-order resonance frequency to two adjacent electrodes 22 in opposite phases. For example, when the electrode 22 has a layout illustrated in FIG. 2, driving signals having opposite phases are input to the two adjacent electrodes 22 in the X direction or in the Y direction in the drawing.

Meanwhile, since the piezoelectric element 20 has a high mechanical quality factor Q, when the vibration member 10 and the piezoelectric element 20 are vibrating, there is a tendency for a high order resonance frequency to be generated together with a fundamental resonance frequency in the piezoelectric element 20 due to the divided vibration. When the high order resonance frequency is generated together with the fundamental resonance frequency, a sound wave is cancelled out between the high order resonance frequency and the fundamental resonance frequency. In this case, the output efficiency of the piezoelectric element 20 decreases. However, in the embodiment, since a second-order resonance frequency is intentionally generated, such a decrease in efficiency can be prevented. In other words, in the embodiment, a large output can be obtained with a second or more-order resonance frequency. This effect can also be obtained in a case where the piezoelectric element 20 is formed of a high molecular material.

### (Second Embodiment)

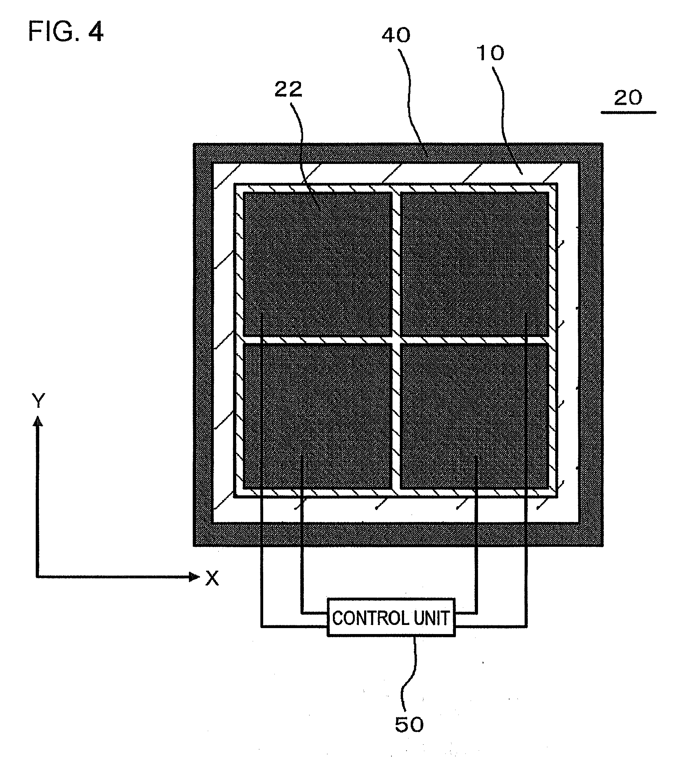

FIG. 4 is a plan view illustrating a configuration of an oscillator according to a second embodiment and corresponds to FIG. 2 according to the first embodiment. The oscillator according to the embodiment has the same configuration as the oscillator according to the first embodiment, except for the planar shapes of the vibration member 10, the piezoelectric element 20, the electrode 22, and the supporting frame 40.

In the embodiment, the planar shapes of the piezoelectric element 20 and the vibration member 10 are rectangular. The piezoelectric element 20 is virtually divided into equal parts in the X direction and the Y direction. In other words, the divided regions in the piezoelectric element 20 have the same shape. The electrode 22 having a rectangular shape is provided in each of the divided regions. The electrode 22 has a similar shape to the region after the piezoelectric element 20 is virtually divided. In the example shown in the drawing, although the piezoelectric element 20 is virtually divided into two equal parts in the X direction and the Y direction, the piezoelectric element 20 may be divided into three or more equal parts. In this case, the oscillator can oscillate a third or more-order resonance frequency with a high efficiency. In addition, a number of divisions in the X direction and a number of divisions in the Y direction may be the same or different from each other. Meanwhile, in any of the above cases, it is preferable that the electrodes 22 be disposed at equal intervals.

In addition, the supporting frame 40 has a shape along a rectangular edge.

The same effects as the first embodiment can also be obtained by the embodiment.

### (Third Embodiment)

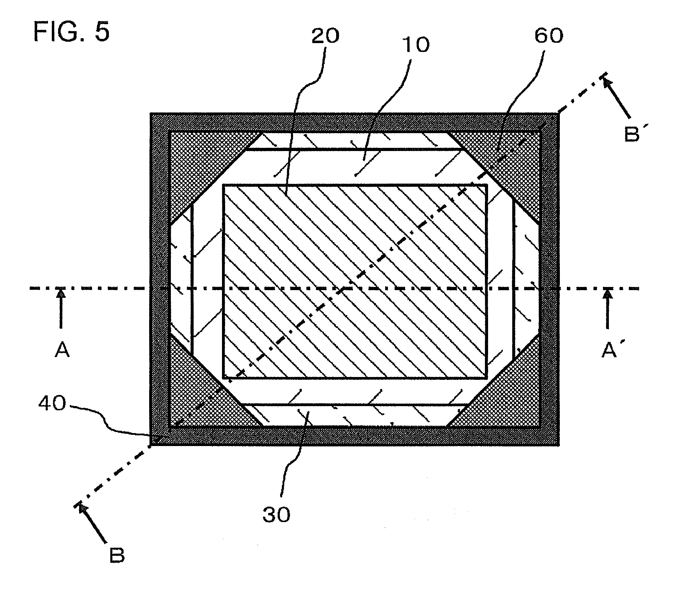

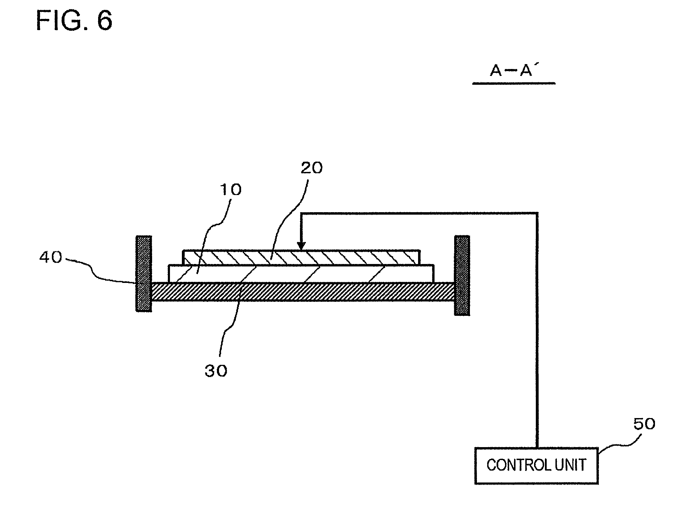

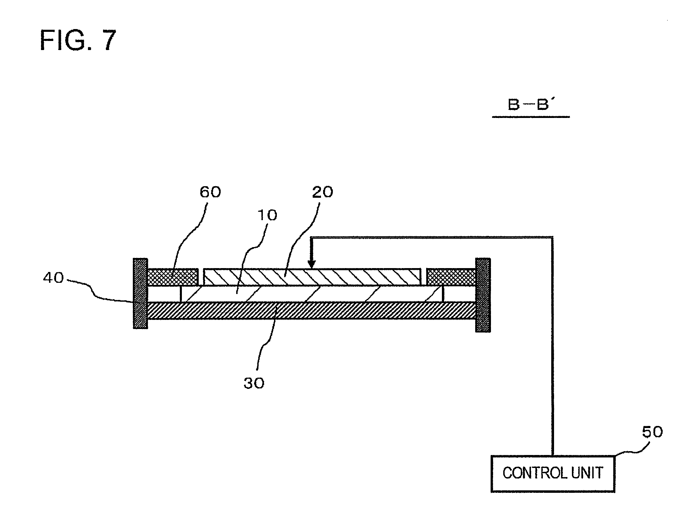

FIG. 5 is a plan view illustrating a configuration of an oscillator according to a third embodiment. FIG. 6 is a cross-sectional view taken along line A-A' of FIG. 5. FIG. 7 is a cross-sectional view taken along line B-B' of FIG. 5. The oscillator has the same configuration as the oscillator according to the first embodiment except for the following configuration.

First, as illustrated in FIG. 5, the plane of the inner circumference of the supporting frame 40 has a polygonal shape of which all corners have an angle that is equal to or less than 180 degrees. A reinforcing member 60 is provided at one or more corners of the supporting frame 40. As illustrated in FIG. 7, the reinforcing member 60 is fixed to the supporting frame 40 and the vibration member 10. Hereinafter, it will be described in detail.

In the embodiment, the vibration member 10 is fixed to one surface of the supporting member 30. The supporting member 30 is formed of a metal, for example, stainless steel or phosphor bronze. The planar shape of the supporting member 30 is larger than the vibration member 10. The supporting member 30 is fixed to the supporting frame 40. In other words, in the embodiment, the vibration member 10 is fixed to the supporting frame 40 through the supporting member 30. The vibration member 10, the piezoelectric element 20, and the supporting member 30 vibrate as a vibrating element.

In the example shown in FIG. 5, the supporting frame 40 has a shape along a rectangular edge. However, the shape of the supporting frame 40 is not limited thereto. For example, the supporting frame 40 may have a regular polygonal shape.

As described above, the reinforcing member 60 is fixed to the supporting frame 40 and the vibration member 10. In the embodiment, the reinforcing member 60 is provided at all corners of the supporting frame 40. The reinforcing members 60 are spaced apart from each other, and do not have any portions which are connected to each other. However, the reinforcing member 60 may be fixed to the supporting member 30 instead of the vibration member 10. In addition, it is preferable that the reinforcing member 60 do not overlap the piezoelectric element 20 when seen in a plan view. A distance between the reinforcing member 60 and the piezoelectric element 20 is preferably as short as possible.

Meanwhile, it can also be seen that the planar shape of the inner circumference of the supporting frame 40 changes by providing the reinforcing members 60. The reinforcing member 60 has a shape in which the inner circumference of the supporting frame 40 comes close to a circle. In the embodiment, the reinforcing member 60 is disposed in such a manner that the planar shape thereof is an isosceles triangle in which a vertex angle thereof is equal to an inner angle of the supporting frame 40, and that the vertex angle overlaps the corner of the supporting frame 40.

Meanwhile, in the embodiment, an electrode provided in the piezoelectric element 20 may be the same as in the first embodiment and may not be divided.

Next, operations and effects of the embodiment will be described. When the inner circumference of the supporting frame 40 has a polygonal shape, the plane of the vibrating element constituted by the vibration member 10, the piezoelectric element 20, and the supporting member 30 also has a polygonal shape. In this case, the width of the vibrating element is not determined to be one. For example, in the example shown in FIG. 5, the width of the vibrating element is maximum in line B-B' and is minimum in line A-A'. In such a case, there is a tendency for the divided vibration described in the first embodiment to occur, and thus there is a tendency for a high order resonance frequency to be generated together with a fundamental resonance frequency. In this case, a sound wave is cancelled out between the high order resonance frequency and the fundamental resonance frequency, and thus the output efficiency of the piezoelectric element 20 decreases.

On the other hand, in the embodiment, since the reinforcing member is provided at the corners of the supporting frame 40, it is possible to reduce the difference between a maximum value and a minimum value of the width of the vibrating element. Therefore, it is possible to prevent the output efficiency of the piezoelectric element 20 from decreasing.

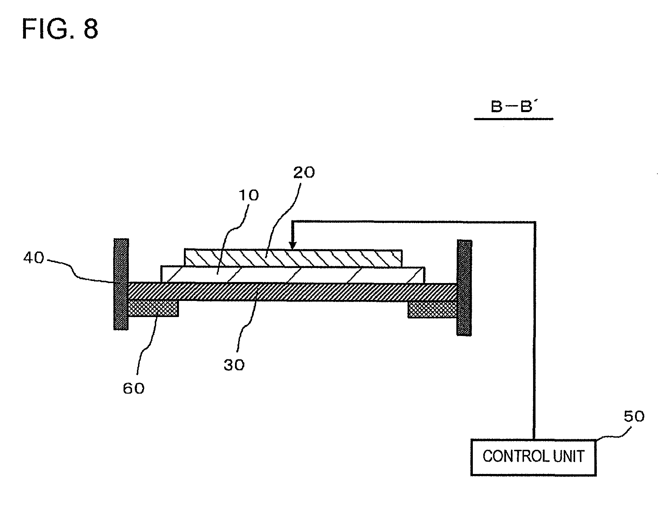

Meanwhile, when the oscillator has the supporting member 30, the reinforcing member 60 may be attached to the supporting member 30. In this case, as illustrated in FIG. 8, the reinforcing member 60 may be attached to a surface of the supporting member 30 on which the vibration member 10 is not provided.

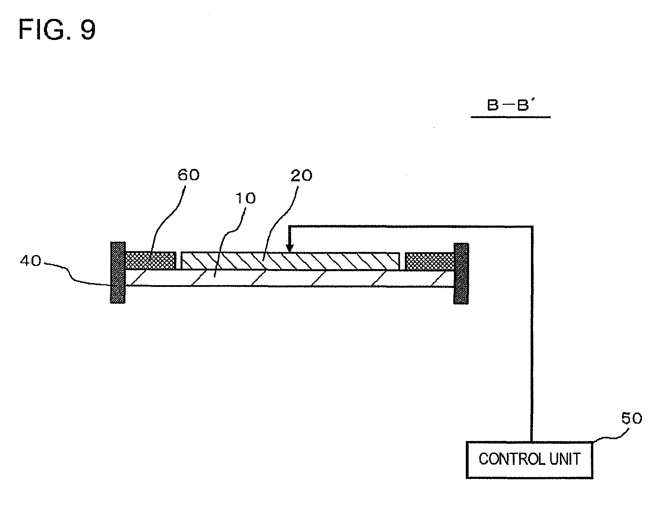

In addition, as illustrated in FIG. 9, the vibration member 10 may be directly fixed to the supporting frame 40 without providing the supporting member 30.

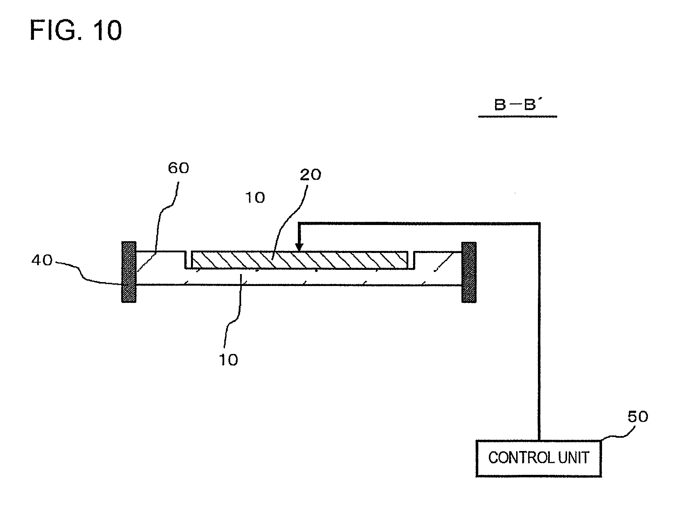

In addition, as illustrated in FIG. 10, when the supporting member 30 is not provided, the reinforcing member 60 may be formed integrally with the vibration member 10. In this case, the portion of the vibration member 10 which is located at the corner of the supporting frame 40 is thicker than other portions. The thick portion serves as the reinforcing member 60.

In any of the modified examples shown in FIGS. 8 to 10, the above-described effects can be obtained.

As described above, although the embodiments of the invention have been set forth with reference to the drawings, they are merely illustrative of the invention, and various configurations other than stated above can be employed.

The application claims the priority based on Japanese Patent Application No. 2011-079027 filed on March 31, 2011, the content of which is incorporated herein by reference.

The invention is further described in the following numbered items:
1. An oscillator comprising:
   a vibration member;
   a piezoelectric element that is attached to the vibration member;
   a plurality of electrodes that are provided on one surface of the piezoelectric element and are two-dimensionally arranged so as to be spaced apart from each other;
   a supporting member that supports an edge of the vibration member; and
   a control unit that inputs an independent driving signal to each of the plurality of electrodes.
2. The oscillator according to item 1, wherein the plurality of electrodes have the same planar shape and are arranged at equal intervals.
3. The oscillator according to item 1 or 2, wherein at least some of the plurality of electrodes are arranged so as to be point-symmetrical to each other based on the center of the piezoelectric element.
4. The oscillator according to any one of items 1 to 3, wherein the piezoelectric element is constituted by a high molecular material indicating a piezoelectric property.
5. An oscillator comprising:
   a vibration member;
   a piezoelectric element that is attached to the vibration member; and
   a frame to which the vibration member is fixed,
   wherein a plane of an inner circumference of the frame has a polygonal shape when seen in a plan view, and
   wherein at least one of corners of the frame has a reinforcing member that is fixed to the frame and the vibration member.
6. The oscillator according to item 5, wherein the reinforcing member does not overlap the piezoelectric element when seen in a plan view.
7. The oscillator according to item 5 or 6, wherein the reinforcing member is provided at all the corners of the frame, and the reinforcing members are spaced apart from each other.
8. The oscillator according to any one of items 5 to 7, wherein the reinforcing member is an isosceles triangle in which a vertex angle is equal to an inner angle of the frame, and the reinforcing member is disposed such that the vertex angle overlaps the corner of the frame.
9. An electronic device having the oscillator according to any one of items 1 to 8.

## Claims

1. An oscillator comprising:
a vibration member (10);
a piezoelectric element (20) that is attached to the vibration member (10); and
a frame (40) to which the vibration member (10) is fixed,
wherein a plane of an inner circumference of the frame (40) has a polygonal shape when seen in a plan view, and
wherein at least one of corners of the frame (40) has a reinforcing member (60) that is fixed to the frame and the vibration member (10).

2. The oscillator according to claim 1, wherein the reinforcing member (60) does not overlap the piezoelectric element (20) when seen in a plan view.

3. The oscillator according to claim 1 or 2, wherein the reinforcing member (60) is provided at all the corners of the frame (40), and the reinforcing members (60) are spaced apart from each other.

4. The oscillator according to any one of claims 1 to 3, wherein the reinforcing member (60) is an isosceles triangle in which a vertex angle is equal to an inner angle of the frame, and the reinforcing member (60) is disposed such that the vertex angle overlaps the corner of the frame (40).

5. An electronic device having the oscillator according to any one of claims 1 to 4.
